# EUROPÄISCHE PATENTANMELDUNG

(11) **EP 2 219 219 A1**
(43) Veröffentlichungstag der Anmeldung: **18.08.2010**
(21) Anmeldenummer: 09016027.6
(22) Anmeldetag: 24.12.2009
(51) Int. Cl.: H01L 23/373, H01L 23/498

(54) **Substrat zur Aufnahme mindestens eines Bauelements und Verfahren zur Herstellung eines Substrats**

(30) Priorität: 16.02.2009 DE 102009000882
(71) Anmelder: SEMIKRON Elektronik GmbH & Co. KG, 90431 Nürnberg (DE)
(72) Erfinder: Braml, Heiko, Dr., 91346 Wiesenttal (DE); Fey, Tobias, Dr., 91058 Erlangen (DE); Göbl, Christian, 90441 Nürnberg (DE); Sagebaum, Ulrich, 90408 Nürnberg (DE)

(57) **Zusammenfassung**

Die Erfindung betrifft ein Substrat zur Aufnahme zumindest eines Bauelements (4), insbesondere eines Leistungshalbleiters, bei dem ein Substratkörper (1) auf zumindest einer Vorder- und/oder einer gegenüberliegenden Rückseite mit einer elektrisch leitfähigen Schicht (3, 3a, 3b) versehen ist. Zur Verbesserung der Wärmeableitung von der elektrisch leitfähigen Schicht (3, 3a, 3b) wird erfindungsgemäß vorgeschlagen, dass zwischen dem Substratkörper (1) und der elektrisch leitfähigen Schicht (3, 3a, 3b) eine elektrisch isolierende Verbindungsschicht (2, 2a, 2b) vorgesehen ist, welche eine aus einem präkeramischen Polymer gebildete duroplastische Matrix aufweist.

## Beschreibung

Die Erfindung betrifft ein Substrat nach dem Obergriff des Anspruchs 1. Sie betrifft ferner ein Verfahren zur Herstellung eines Substrats.

Nach dem Stand der Technik sind Substrate zur Aufnahme elektrischer oder elektronischer Bauelemente allgemein bekannt. Derartige Substrate bestehen im Allgemeinen aus einer aus einem elektrisch isolierenden Material hergestellten Platte, welche zumindest auf einer Vorder- und/oder einer gegenüberliegenden Rückseite mit einer elektrisch leitfähigen Schicht versehen ist. Die Platte kann beispielsweise aus einem elektrisch isolierenden Kunststoff oder einer Keramik hergestellt sein. Insbesondere zur Herstellung von mit Leistungshalbleitern bestückten Modulen werden nach dem Stand der Technik beispielsweise DCB-Substrate eingesetzt. Dabei wird als elektrischer Isolator eine aus Aluminiumoxid oder Aluminiumnitrit hergestellte Platte verwendet. Darauf sind Leiterbahnen in einem Hochtemperatur-Schmelz- und Diffusionsprozess aus reinem Kupfer aufgebracht. Solche DCB-Substrate zeichnen sich durch eine hohe Wärmeableitfähigkeit und Temperaturbeständigkeit aus.

Die Herstellung von DCB-Substraten ist gleichwohl aufwändig und teuer. Bedingt durch die hohen Temperaturen bei der Herstellung kann eine Durchbiegung solcher Substrate nicht immer vermieden werden. Das kann in der weiteren Verarbeitungskette zu einem Bruch des DCB-Substrats führen.

Aufgabe der Erfindung ist es, die Nachteile nach dem Stand der Technik zu beseitigen. Es soll insbesondere ein einfach und kostengünstig herstellbares Substrat angegeben werden, welches eine hohe Wärmeleitfähigkeit λ aufweist. Ferner soll ein Verfahren zur Herstellung eines solchen Substrats angegeben werden.

Diese Aufgaben werden durch die Merkmale der Ansprüche 1 und 13 gelöst. Zweckmäßige Ausgestaltungen der Erfindung ergeben sich aus den Merkmalen der Ansprüche 2 bis 12 und 14 bis 28.

Nach Maßgabe der Erfindung ist vorgesehen, dass zwischen dem Substratkörper und der elektrisch leitfähigen Schicht eine elektrisch isolierende Verbindungsschicht vorgesehen ist, welche eine aus einem präkeramischen Polymer gebildete duroplastische Matrix aufweist. Die vorgeschlagene Verbindungsschicht weist eine hervorragende Wärmeleitfähigkeit λ auf. Sie zeichnet sich ferner durch eine hohe Temperaturbeständigkeit aus. Sie hält Betriebstemperaturen von bis zu 300°C stand. Wegen der elektrisch isolierenden Eigenschaften der Verbindungsschicht kann als Substratkörper ein beliebiges Material, insbesondere auch ein elektrisch leitfähiges Material, verwendet werden. Das ermöglicht insgesamt eine besonders einfache und kostengünstige Herstellung eines Substrats mit einer hervorragenden Wärmeleitfähigkeit Ä.

Unter dem Begriff "präkeramisches Polymer" wird ein Polymer verstanden, welches z. B. mit zunehmender Temperatur zunächst in einen gelartigen und nachfolgend in einen duroplastischen Zustand übergeht. Im duroplastischen Zustand weist ein präkeramisches Polymer in der Regel eine Temperaturbeständigkeit von bis zu 300°C auf. Bei einer weiteren Temperaturerhöhung können aus präkeramischen Polymeren keramische Werkstoffe hergestellt werden. Zu präkeramischen Polymeren gehören beispielsweise Polysilane, Polycarbosilane und Polyorganosiloxan.

Nach einer vorteilhaften Ausgestaltung der Erfindung ist vorgesehen, dass das präkeramische Polymer mit einem Füllgrad von bis zu 80 Vol.% mit einem Füllstoff gefüllt ist. Damit kann insbesondere die Wärmeleitfähigkeit λ der unter Verwendung des präkeramischen Polymers hergestellten Verbindungsschicht weiter erhöht werden.

Zweckmäßigerweise handelt es sich bei dem Füllstoff um ein aus einem keramischen Material gebildetes Pulver mit einer mittleren Korngröße im Bereich von 0,5 bis 200 µm. Das vorgeschlagene keramische Material ist elektrisch isolierend und weitgehend inert. Dessen Zusatz führt nicht zu unerwünschten chemischen Reaktionen mit dem präkeramischen Material. Die vorgeschlagene mittlere Korngröße ermöglicht ein Auftragen der Verbindungsschicht mittels Dispenser, Jet, Drucktechniken, Sieb oder Schablone.

Die Wärmeleitfähigkeit λ des keramischen Materials ist zweckmäßigerweise bei Raumtemperatur größer als 10 W/mK, vorzugsweise größer als 20 W/mK. Je nach Füllgrad gelingt es damit, die Wärmeleitfähigkeit Ä des mit dem keramischen Material gefüllten präkeramischen Polymers auf Werte oberhalb 2 W/mK zu steigern. Damit eignet sich die Verbindungsschicht insbesondere zur Herstellung von Substraten für im Betrieb eine relativ große Wärme freisetzende Leistungshalbleiter.

Das keramische Material ist zweckmäßigerweise aus der folgenden Gruppe ausgewählt: BN, SiC, Si₃N₄, AlN, Steatit, Cordierit. Die vorgeschlagenen keramischen Materialien zeichnen sich durch eine hohe Wärmeleitfähigkeit λ aus. Sie sind außerdem elektrisch isolierend.

Weiterhin hat es sich als zweckmäßig erwiesen, dass das präkeramische Polymer aus der folgenden Gruppe ausgewählt ist: Polysiloxan, Polysilazan, Polycarbosilan.

Die elektrisch leitfähige Schicht ist zweckmäßigerweise aus einem Metall, vorzugsweise Aluminium oder Kupfer, oder einem Halbleiter hergestellt. Dabei kann die elektrisch leitfähige Schicht zunächst im Wesentlichen vollflächig die Vorder-und/oder Rückseite des Substratkörpers bedecken. Eine gewünschte Leiterbahnstruktur kann dann nachfolgend mittels herkömmlicher Techniken, beispielsweise Maskieren und nachfolgendes Ätzen, hergestellt werden. Es kann aber auch sein, dass die elektrisch leitfähige Schicht in Form einer vorgegebenen Leiterbahnstruktur vorliegt und dann mittels der Verbindungsschicht auf den Substratkörper auflaminiert wird.

Nach einer vorteilhaften Ausgestaltung der Erfindung ist der Substratkörper aus einer Keramik, einem Kunststoff oder einem Kunststoffverbundmaterial hergestellt. Sofern die vorgenannten Materialien elektrisch isolierende Eigenschaften aufweisen, lassen sich auf einfache Weise Durchkontaktierungen herstellen.

Nach einer besonders vorteilhaften Ausgestaltung ist der Substratkörper aus einem Material mit einer Wärmeleitfähigkeit λ von zumindest 150 W/mK, vorzugsweise einer Keramik oder einem Metall, hergestellt. Der Substratkörper kann insbesondere auch ein aus einer Aluminium- oder Kupferlegierung hergestellter Kühlkörper sein. Die Wärmeleitfähigkeit λ eines derartigen Substrats ist ausgezeichnet.

Nach einer weiteren Ausgestaltung ist vorgesehen, dass die Verbindungsschicht sich seitlich über einen durch die elektrisch leitfähige Schicht definierten Überdeckungsbereich hinaus erstreckt. Sofern die elektrisch leitfähige Schicht insbesondere in Form einer Leiterbahnstruktur vorliegt, erstreckt sich die Verbindungsschicht in einem Streifen vorgegebener Breite rechts und links jeder Leiterbahn. Damit wird der Ausbildung von Kriechströmen entgegengewirkt.

Nach weiterer Maßgabe der Erfindung ist ein Verfahren zur Herstellung eines Substrats zur Aufnahme zumindest eines Bauelements, insbesondere eines Leistungshalbleiters, vorgesehen, bei dem eine elektrisch leitfähige Schicht unter Verwendung eines präkeramischen Polymers mit einem Substratkörper verbunden und nachfolgend das präkeramische Polymer in eine duroplastische Form überführt wird, so dass sich eine die Schicht mit dem Substratkörper verbindende Verbindungsschicht ausbildet. - Das vorgeschlagene Verfahren ist relativ einfach und kostengünstig durchführbar. Es ist insbesondere nicht unbedingt erforderlich, einen in einem aufwändigen Sinterprozess hergestellten Substratkörper bereitzustellen. Unter Verwendung der vorgeschlagenen Verbindungsschicht lässt sich auf einfache Weise die elektrisch leitfähige Schicht mit einem beliebigen Substratkörper verbinden. Insbesondere bei Verwendung eines aus einem Metall hergestellten Substratkörper zeichnet sich das mit dem erfindungsgemäßen Verfahren hergestellte Substrat durch eine hervorragende Wärmeleitfähigkeit λ sowie eine hohe Formtreue aus.

Unter dem Begriff "Schicht" wird sowohl eine vollflächige Beschichtung einer Vorder- und/oder Rückseite eines, vorzugsweise plattenförmig ausgestalteten, Substratkörpers als auch lediglich eine abschnittsweise Beschichtung verstanden. Im Falle der abschnittsweisen Beschichtung kann die Schicht in Form einer vorgegebenen Leitbahnstruktur ausgebildet sein.

Das Auftragen des präkeramischen Polymers kann zweckmäßigerweise mittels Siebdruck, unter Verwendung einer Schablone, eines Nadeldispensers oder einer Jetdüse erfolgen. Präkeramische Polymere zeichnen sich bei Raumtemperatur durch eine Tropfzeit von 6 bis 9 Monaten aus. Infolgedessen ist ein Auftragen der Verbindungsschicht mittels herkömmlicher Techniken ohne Weiteres möglich.

Nach einer weiteren vorteilhaften Ausgestaltung liegt die elektrisch leitfähige Schicht vor dem Verbinden mit dem Substratkörper in Form einer vorgegebenen Leiterbahnstruktur vor. Die Leiterbahnstruktur kann mittels Stanzen hergestellt werden. Selbstverständlich ist es auch möglich, zur Herstellung der Leiterbahnstrukturen andere Verfahren zu verwenden, beispielsweise Laserschneiden, Wasserstrahlschneiden oder dgl. Die Verbindungsschicht wird zweckmäßigerweise in einem sich seitlich über einen durch die elektrisch leitfähige Schicht definierten Überdeckungsbereich auf den Substratkörper aufgetragen. D. h. die Verbindungsschicht erstreckt sich zweckmäßigerweise in einem Bereich vorgegebener Breite rechts und links einer Leiterbahn. Damit wird der Ausbildung von Kriechströmen entgegengewirkt. Zu diesem Zweck kann es auch sein, dass die elektrisch leitfähige Schicht mit dem präkeramischen Polymer abgedeckt ist.

Nach einer Variante des Verfahrens ist es auch möglich, zunächst auf eine Vorder Vorder- und/oder Rückseite des Substratkörpers mittels der Verbindungsschicht eine im Wesentlichen vollflächige elektrisch leitfähige Schicht aufzubringen. Eine vorgegebene Leiterbahnstruktur kann dann mittels Maskieren der Schicht und nachfolgendes Ätzen hergestellt werden.

Das präkeramische Polymer wird zum Überführen in die duroplastische Form zweckmäßigerweise auf eine Temperatur im Bereich von 100 bis 300°C, vorzugsweise 150 bis 250°C, für eine Haltezeit von 15 bis 300 Minuten, vorzugsweise 30 bis 60 Minuten, aufgeheizt. Selbstverständlich ist es auch möglich, eine Vernetzung des präkeramischen Polymers auf andere Art zu erzielen. Beispielsweise kann das durch Zusatz geeigneter chemischer Stoffe, mittels Strahlung, vorzugsweise UV-Strahlung, oder dgl. erfolgen.

Wegen der weiteren vorteilhaften Ausgestaltungen des Verfahrens wird auf die zum Substrat erläuterten vorteilhaften Ausgestaltungsmerkmale verwiesen. Sie können sinngemäß Ausgestaltungen des Verfahrens bilden.

Nachfolgend werden Ausführungsbeispiele der Erfindung anhand der Zeichnungen näher erläutert. Es zeigen:
- Fig. 1: eine schematische Schnittansicht durch ein erstes Substrat mit darauf aufgenommenen Bauelementen und
- Fig. 2: eine schematische Schnittansicht durch ein zweites Substrat mit darauf aufgenommenen Bauelementen.

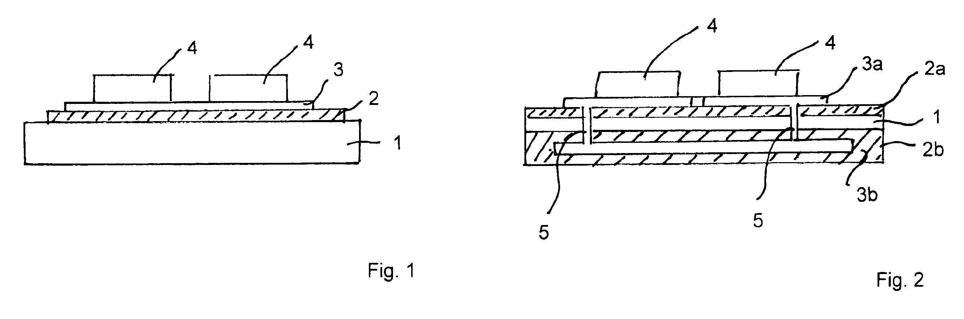

In Fig. 1 ist auf einem Substratkörper 1 eine Verbindungsschicht 2 vorgesehen. Die Verbindungsschicht 2 verbindet eine elektrisch leitfähige Schicht 3 mit dem Substratkörper 1. Die elektrisch leitfähige Schicht 3, bei der es sich beispielsweise um eine Leiterbahnstruktur handeln kann, ist mit Bauelementen 4 verbunden. Bei den Bauelementen 4 kann es sich um halbleitende Bauelemente, insbesondere Leistungshalbleiter, handeln. Die Bauelemente 4 sind beispielsweise mittels einer herkömmlichen Lötverbindung mit der elektrisch leitfähigen Schicht 3 verbunden.

Die Verbindungsschicht 2 ist elektrisch isolierend. Sie ist vorzugsweise aus Polysiloxan hergestellt, welches zu 60 bis 80 Vol.% mit einem Füllstoff gefüllt ist. Bei dem Füllstoff handelt es sich zweckmäßigerweise um SiC mit einer mittleren Korngröße im Bereich von 2 bis 10 µm. Eine solche Verbindungsschicht 2 weist eine hervorragende Wärmeleitfähigkeit λ von mehr als 20 W/mK auf.

Der Substratkörper 1 ist aus einem Metall, vorzugsweise einer Kupfer- oder Aluminiumlegierung, hergestellt. Der Substratkörper 1 kann nach Art eines Kühlkörpers hergestellt sein und beispielsweise Kühlrippen aufweisen (hier nicht gezeigt).

Die Verbindungsschicht 2 ermöglicht wegen ihrer hohen Wärmeleitfähigkeit λ eine schnelle Ableitung der von den Bauelementen 4 im Betrieb erzeugten Wärme auf den Substratkörper 1 und von da in die Umgebung. Das den Substratkörper 1, die Verbindungsschicht 2 und die elektrisch leitfähige Schicht 3 umfassende Substrat zeichnet sich also durch eine hervorragende Wärmeableitfähigkeit aus. Es lässt sich überdies einfach und kostengünstig herstellen.

Fig. 2 zeigt eine schematische Schnittansicht durch ein zweites Substrat mit darauf aufgenommenen Bauelementen 4. Der Substratkörper 1 ist hier an seiner Vorder- und Rückseite mit einer ersten 2a und einer zweiten Verbindungsschicht 2b versehen. An einer den Bauelementen 4 zugewandten Vorderseite verbindet die erste Verbindungsschicht 2a eine erste elektrisch leitfähige Schicht 3a mit dem Substratkörper 1. An einer den Bauelementen 4 abgewandten Rückseite ist eine zweite elektrisch leitfähige Schicht 3b in die zweite Verbindungsschicht 2b eingebettet. Mit dem Bezugszeichen 5 sind Durchkontaktierungen bezeichnet, welche die erste elektrisch leitfähige Schicht 3a mit der zweiten elektrisch leitfähigen Schicht 3b verbinden.

Der Substratkörper 1 ist hier aus einem elektrisch isolierenden Material, beispielsweise Aluminiumoxid, einem elektrisch isolierenden Kunststoff oder dgl., hergestellt. Die in Fig. 2 gezeigte Baugruppe kann beispielsweise mittels der an der Rückseite vorgesehenen zweien Verbindungsschicht 2b mit einem aus Metall hergestellten Kühlkörper (hier nicht gezeigt) verbunden sein. Die Verbindungsschichten 2a, 2b sind - ähnlich wie bei dem in Fig. 1 gezeigten Ausführungsbeispiel - wiederum aus einem in duroplastischer Form vorliegenden präkeramischen Polymer hergestellt, welches mit einem Füllstoff gefüllt ist.

### Bezugszeichenliste

- 1: Substratkörper
- 2, 2a, 2b: Verbindungsschicht
- 3, 3a, 3b: elektrisch leitfähige Schicht
- 4: Bauelement
- 5: Durchkontaktierung

## Patentansprüche

1. Substrat zur Aufnahme zumindest eines Bauelements (4), insbesondere eines Leistungshalbleiters, bei dem ein Substratkörper (1) auf zumindest einer Vorder- und/oder einer gegenüberliegenden Rückseite mit einer elektrisch leitfähigen Schicht (3, 3a, 3b) versehen ist,
**dadurch gekennzeichnet, dass**
zwischen dem Substratkörper (1) und der elektrisch leitfähigen Schicht (3, 3a, 3b) eine elektrisch isolierende Verbindungsschicht (2, 2a, 2b) vorgesehen ist, welche eine aus einem präkeramischen Polymer gebildete duroplastische Matrix aufweist.

2. Substrat nach Anspruch 1, wobei das präkeramische Polymer mit einem Füllgrad von bis zu 80 Vol.% mit einem Füllstoff gefüllt ist.

3. Substrat nach einem der vorhergehenden Ansprüche, wobei der Füllstoff ein aus einem keramischen Material gebildetes Pulver mit einer mittleren Korngröße im Bereich von 0,5 bis 500 µm ist.

4. Substrat nach einem der vorhergehenden Ansprüche, wobei die Wärmeleitfähigkeit λ des keramischen Materials bei Raumtemperatur größer als 10 W/mK, vorzugsweise größer als 20 W/mK, ist.

5. Substrat nach einem der vorhergehenden Ansprüche, wobei das keramische Material aus der folgenden Gruppe ausgewählt ist: BN, SiC, Si₃N₄, AlN, Steatit, Cordierit.

6. Substrat nach einem der vorhergehenden Ansprüche, wobei das präkeramische Polymer aus der folgenden Gruppe ausgewählt ist: Polysiloxan, Polysilazan, Polycarbosilan.

7. Substrat nach einem der vorhergehenden Ansprüche, wobei die elektrisch leitfähige Schicht (3, 3a, 3b) aus einem Metall, vorzugsweise Aluminium oder Kupfer, oder einem Halbleiter hergestellt ist.

8. Substrat nach einem der vorhergehenden Ansprüche, wobei die elektrisch leitfähige Schicht (3, 3a, 3b) in Form einer vorgegebenen Leiterbahnstruktur vorliegt.

9. Substrat nach einem der vorhergehenden Ansprüche, wobei der Substratkörper (1) aus einer Keramik, einem Kunststoff oder Kunststoffverbundmaterial hergestellt ist.

10. Substrat nach einem der Ansprüche 1 bis 8, wobei der Substratkörper (1) aus einem Material mit einer Wärmeleitfähigkeit λ von zumindest 150 W/mK, vorzugsweise einer Keramik oder einem Metall, hergestellt ist.

11. Substrat nach Anspruch 10, wobei der Substratkörper (1) ein aus einer Aluminium- oder Kupferlegierung hergestellter Kühlkörper ist.

12. Substrat nach einem der vorhergehenden Ansprüche, wobei die Verbindungsschicht (2, 2a, 2b) sich seitlich über einen durch die elektrisch leitfähige Schicht (3, 3a, 3b) definierten Überdeckungsbereich hinaus erstreckt.

13. Verfahren zur Herstellung eines Substrats zur Aufnahme zumindest eines Bauelements (4), insbesondere eines Leistungshalbleiters, bei dem eine elektrisch leitfähige Schicht (3, 3a, 3b) unter Verwendung eines präkeramischen Polymers mit einem Substratkörper (1) verbunden und nachfolgend das präkeramische Polymer in eine duroplastische Form überführt wird, so dass sich eine die Schicht (3, 3a, 3b) mit dem Substratkörper (1) verbindende Verbindungsschicht (2, 2a, 2b) ausbildet.

14. Verfahren nach Anspruch 13, wobei das Auftragen des präkeramischen Polymers mittels Siebdruck, unter Verwendung einer Schablone, eines Nadeldispensers oder einer Jetdüse erfolgt.

15. Verfahren nach einem der Ansprüche 13 oder 14, wobei die elektrisch leitfähige Schicht (3, 3a, 3b) vor dem Verbinden mit dem Substratkörper (1) in Form einer vorgegebenen Leiterbahnstruktur vorliegt.

16. Verfahren nach einem der Anspruch 15, wobei die Leiterbahnstruktur mittels Stanzen hergestellt wird.

17. Verfahren nach einem der Ansprüche 13 bis 16, wobei die Verbindungsschicht (2, 2a, 2b) in einem sich seitlich über einen durch die elektrisch leitfähige Schicht (3, 3a, 3b) definierten Überdeckungsbereich auf den Substratkörper (1) aufgetragen wird.

18. Verfahren nach einem der Ansprüche 13 oder 14, wobei eine vorgegebene Leiterbahnstruktur mittels Maskieren der Schicht (3, 3a, 3b) und nachfolgendes Ätzen hergestellt wird.

19. Verfahren nach einem der Ansprüche 13 bis 18, wobei das präkeramische Polymer zum Überführen in die duroplastische Form auf eine Temperatur im Bereich von 100 bis 300°C, vorzugsweise 150 bis 250°C, für eine Haltezeit von 15 bis 300 Minuten, vorzugsweise 30 bis 60 Minuten, aufgeheizt wird.

20. Verfahren nach einem der Ansprüche 13 bis 19, wobei das präkeramische Polymer mit einem Füllgrad von bis zu 80 Vol.% mit einem Füllstoff gefüllt ist.

21. Verfahren nach einem der Ansprüche 13 bis 20, wobei der Füllstoff ein aus einem keramischen Material gebildetes Pulver mit einer mittleren Korngröße im Bereich von 0,5 bis 500 µm ist.

22. Verfahren nach Anspruch 21, wobei die Wärmeleitfähigkeit λ des keramischen Materials bei Raumtemperatur größer als 10 W/mK, vorzugsweise größer als 20 W/mK, ist.

23. Verfahren nach einem der Ansprüche 21 oder 22, wobei das keramische Material aus der folgenden Gruppe ausgewählt ist: BN, SiC, Si₃N₄, AlN, Steatit, Corierit.

24. Verfahren nach einem der Ansprüche 13 bis 23, wobei das präkeramische Polymer aus der folgenden Gruppe ausgewählt ist: Polysiloxan, Polysilazan, Polycarbosilan ist.

25. Verfahren nach einem der Ansprüche 13 bis 24, wobei die elektrisch leitfähige Schicht (3, 3a, 3b) aus einem Metall, vorzugsweise Aluminium oder Kupfer, oder einem Halbleiter hergestellt ist.

26. Verfahren nach einem der Ansprüche 13 bis 25, wobei der Substratkörper (1) aus einer Keramik, einem Kunststoff oder Kunststoffverbundmaterial hergestellt ist.

27. Verfahren nach einem der Ansprüche 13 bis 25, wobei der Substratkörper (1) aus einem Material mit einer Wärmeleitfähigkeit λ von zumindest 150 W/mK, vorzugsweise einer Keramik oder einem Metall, hergestellt ist.

28. Verfahren nach Anspruch 27, wobei als Substratkörper (1) ein aus einer Aluminium- oder Kupferlegierung hergestellter Kühlkörper verwendet wird.
